# EUROPÄISCHE PATENTSCHRIFT

(11) **EP 1 435 524 B1**
(45) Veröffentlichungstag und Bekanntmachung des Hinweises auf die Patenterteilung: **21.06.2006**
(21) Anmeldenummer: 04005840.6
(22) Anmeldetag: 09.12.2000
(51) Int. Cl.: G01R 31/36, G01R 1/20

(54) **Batteriesensorvorrichtung**
Battery sensor device
Dispositif capteur pour batterie

(30) Priorität: 18.12.1999 DE 19961311
(43) Veröffentlichungstag der Anmeldung: 07.07.2004
(62) Teilanmeldung aus: 00987376.1
(73) Patentinhaber: Bayerische Motoren Werke Aktiengesellschaft, 80809 München (DE)
(72) Erfinder: Heim, Andreas, 84032 Altdorf (DE)

(56) Entgegenhaltungen:
- WO-A-99/54744
- DE-A- 3 532 044
- NN-A-
- US-A- 4 572 878
- US-A- 5 877 563

## Beschreibung

Die Erfindung bezieht sich auf einen Batteriesensor.

Eine Batteriesensorvorrichtung ist beispielsweise aus der US 5,939,861 bekannt. Bei dieser bekannten Vorrichtung ist der Batteriesensor in einer eigens für diesen vorgesehenen Vertiefung im Batteriedeckel angeordnet und muß an beiden Polen der Batterie befestigt werden.

Für die Überwachung, Steuerung und Regelung eines Kraftfahrzeugbordnetzes, wie Energieverteilung, Energiesteuerung und insbesondere Ladebilanzierung der Batterien, sind diverse Vorrichtungen und Verfahren bekannt. Je nach Anwendungsfall sind üblicherweise zumindest die Meßgrößen Batteriestrom, Batteriespannung und Batterietemperatur notwendig. Zur Erfassung des Batteriestroms werden üblicherweise Sensoren in der Anschlußleitung zur Batterie verwendet. Die Batteriespannung und die Batterietemperatur werden meist mittels separater Sensoren direkt an den Batteriepolen oder entfernt davon gemessen. Nach dem Stand der Technik werden somit üblicherweise drei völlig unabhängige Einrichtungen verwendet, für die in jedem Fahrzeug gesondert Bauraum geschaffen werden muß und deren Informationen zur Weiterverarbeitung meist an übergeordnete Steuergeräte weitergeleitet werden müssen. Für die Strommeßung werden zum Beispeil Meßshunts werwendet.

Zum weiteren technischen Hintergrund im Hinblick auf Batteriesensorvorrichtungen wird auf die DE 35 32 044 A1 und auf die WO 99/54744 A1 verwiesen. Im Hinblick auf Meßshunts wird auf die EP 605800 A1, die DE 195 10662 A1 und auf die US 3330027 A verwiesen.

Es ist Aufgabe der Erfindung, einen einen Meßshunt und einer Elektronikeinheit umfassenden Batteriesensor eingangs genannter Art derart zu verbessern, daß die Einbaukosten und der Logistikaufwand reduziert sowie die Meßgenauigkeit erhöht werden.

Diese Aufgabe wird durch die Merkmale des Patentanspruchs 1 gelöst. Vorteilhafte Weiterbildungen der Erfindung sind die Gegenstände der abhängigen Ansprüche.

Durch die Erfindung wird ein integrierter Batteriesensor geschaffen, der in jedes Fahrzeug mit nur wenig Zusatzaufwand bei nur geringem erforderlichen Bauraum eingebaut werden kann. Zusätzlich wird durch die kompakte Bauform und die Integration mehrerer notwendiger Bauteile die Ausfallwahrscheinlichkeit gesenkt.

In der Zeichnung ist ein Ausführungsbeispiel der Erfindung dargestellt. Es zeigen
- Fig. 1a: die Draufsicht einer ersten möglichen Konstruktion des erfindungsgemäßen Batteriesensors in einer integrierten Baueinheit bestehend aus Batteriesensor und Befestigungsvorrichtung in zweidimensionaler Darstellung,
- Fig. 1b: den Schnitt B-B durch Fig. 1a,
- Fig. 2: die erste mögliche Konstruktion der integrierten Baueinheit bestehend aus dem erfindungsgemäßen Batteriesensor und der Befestigungsvorrichtung in dreidimensionaler Darstellung,
- Fig. 3: eine genauere schematische Darstellung des Batteriesensors bestehend aus dem Meßshunt und der Elektronikeinheit,
- Fig. 4: eine genauere schematische Darstellung der Elektronikeinheit,
- Fig. 5a: schematisch eine zweite mögliche Konstruktion der integrierten Baueinheit bestehend aus Batteriesensor und Befestigungsvorrichtung in zweidimensionaler Darstellung,
- Fig. 5b: eine leicht von Fig. 5a abgewandelte Konstruktion,
- Fig. 6a: und eine Möglichkeit zur Befestigung der Elektronikeinheit auf dem Meßshunt,
- Fig. 6b: weitere Möglichkeiten zur Befestigung der Elektronikeinheit auf dem Meßshunt,
- Fig. 7a: eine mögliche Ausgestaltung des Meßshunts.

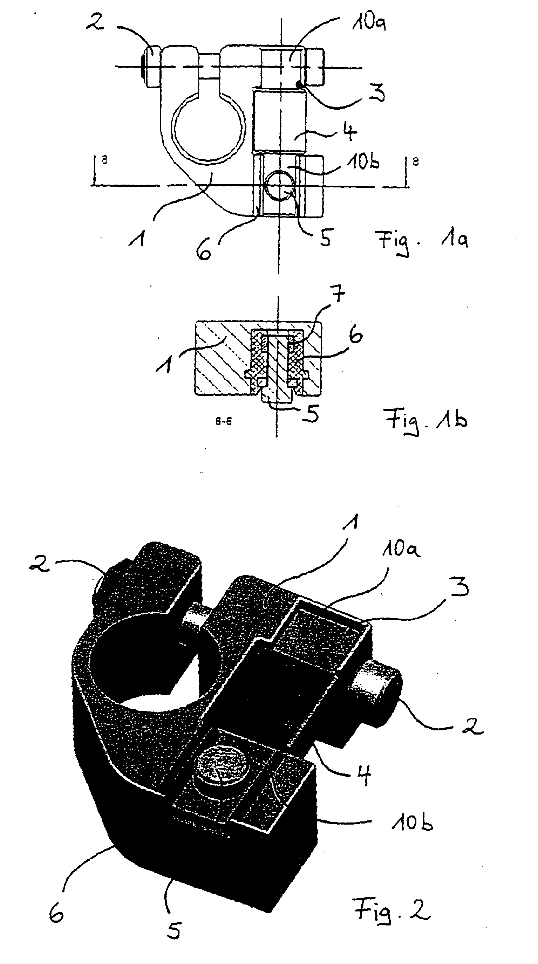

In Fig. 1a ist die Befestigungsvorrichtung des Batteriesensors als vorzugsweise übliche Batterie-Messingklemme bestehend aus einem Klemmenkörper 1 und einer Klemmschraube 2 dargestellt. Der erfindungsgemäße Batteriesensor 3, 4 ist im wesentlichen aus einem Meßshunt 3 und einer Elektronikeinheit 4 aufgebaut. In Fig. 1a sind lediglich die zwei als mechanische Träger ausgebildeten Widerstandsanschlüsse (10a, 10b; vgl. auch Fig. 2) des Meßshunts 3 und eine Kunststoffumspritzung der Elektronikeinheit 4 zu sehen. Der Batteriesensor 3,4 und die Befestigungsvorrichtung 1, 2 sind Vorzugsweise zu einer integrierten Baueinheit zusammengefaßt. Die Befestigungsvorrichtung 1,2 muß nur an einem einzigen Pol einer Batterie, z. B. am Minuspol, angeschlossen werden. Die Baueinheit, bestehend aus der Befestigungsvorrichtung 1, 2 und dem Batteriesensor 3,4, ist in Form und Größe an die (hier nicht eigens dargestellte) bekannte, nach der polnischen DIN 72311 (Teil15) spezifizierte Batteriepolwanne angepaßt.

Der erste, in Fig. 1a oben dargestellte Widerstandsanschluß 10a ist leitend, der zweite, in Fig. 1a unten dargestellte Widerstandsanschluß 10b ist isolierend über ein Isolierteil 6 am Klemmenkörper 1 befestigt. Am zweiten Widerstandsanschluß 10b ist beispielsweise mittels einer Schraube 5 und einer im Isolierteil 6 eingebetteten Schraubenmutter 7 (vgl. Fig. 1b) der Kabelschuh eines gewöhnlichen Anschlußkabels anschließbar. Beim vorliegenden Ausführungsbeispiel, bei dem die Klemme 1, 2 am Minuspol der Batterie angeschlossen werden soll, verbindet das (hier nicht dargestellte) Anschlußkabel den ausgangsseitigen Widerstandsanschluß 10b des Meßshunts 3 mit der Kraftfahrzeugmasse.

In Fig. 2 ist zur Verdeutlichung der Konstruktion die in Fig. 1a und 1b dargestellte Baueinheit dreidimensional dargestellt. Die gleichen Bauteile sind mit gleichen Bezugszeichen versehen.

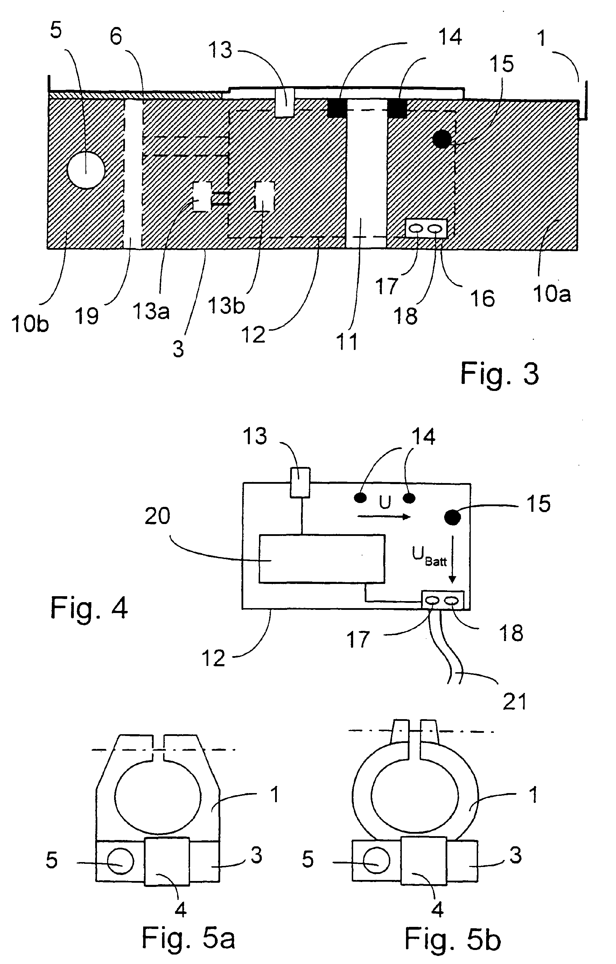

In Fig. 3 sind im wesentlichen die Details des Meßshunts 3, mögliche Anordnungen eines Temperatursensors 13, 13a oder 13b und einer möglichen Verbindung dieser Bauteile mit der Elektronikeinheit 4 dargestellt. Der Meßshunt 3 besteht aus einem Widerstandselement 11 und zwei planaren Widerstandsanschlüssen 10a und 10b. Die Widerstandsanschlüsse 10a und 10b sind vorzugsweise stabil ausgebildete Kupferflächen. Das Material des

Widerstandselements 11 ist vorzugsweise Manganin, Zeranin oder Isaohm. Kupfer und Manganin/Zeranin/lsaohm weisen in etwa den gleichen Temperaturausdehnungskoeffizienten wie das übliche Platinenmaterial FR4 (Mischmaterial mit Epoxyharz als Hauptbestandteil) auf. Dieses Platinenmaterial wird vorzugsweise auch für die Trägerplatine 12 der Elektronikeinheit 4 verwendet, die in Fig. 3 ohne Kunststoffumspritzung dargestellt ist. Daher kann die Trägerplatine 12 der Elektronikeinheit 4 gemäß Fig. 3 ähnlich der SMD-Technik über bloße Lötstellen 14 an den Widerstandsanschlüssen 10a und 10b befestigt werden. Alternativ kann die Trägerplatine 12 auch über um 90° nach oben gebogene kurze Senseleitungen der Widerstandsanschlüsse 10a und 10b am Meßshunt 3 leitend befestigt werden. Die Lötstellen 14 oder die Anschlüsse der Senseleitungen sind möglichst nahe am Widerstandselement 11 angeordnet. Über die Lötstellen 14 wird das Widerstandselement 11 schaltungstechnisch in die Elektronikeinheit 4 integriert.

Die Elektronikeinheit 4 bzw. die Trägerplatine 12 ist in Fig. 3 mit einem Temperatursensor 13 zur Messung der Batterietemperatur verbunden. Alternative Anordnungen des Temperatursensors sind gestrichelt mit den Bezugszeichen 13a und 13 b dargestellt. Der Temperatursensor 13 ist wärmeleitend beispielsweise mittels Wärmeleitkleber direkt am Klemmenkörper 1 angeordnet. Diese Anordnung ermöglicht eine sehr genaue Temperaturmessung, ist jedoch etwas aufwendiger als die Anordnung der Temperatursensoren 13a und 13b, die wärmeleitend am Widerstandsanschluß 10b angebracht sind. Der Temperatursensor 13a ist vereinfacht über Anschlußdrähte mit der Trägerplatine 12 befestigt. Der Temperatursensor 13b ist beispielsweise über Lötstellen mit der Trägerplatine 12 verbunden, um die Anschlußdrähte zu verhindern. Für den Temperatursensor 13b ist jedoch ggf. eine Aussparung in der Trägerplatine 12 erforderlich.

Die Elektronikeinheit 4 bzw. die Trägerplatine 12 weist einen beispielsweise zweipoligen Stecker 16 auf. Am Pin 18 des Steckers 16 ist ein Versorgungskabel zum anderen Pol der Batterie, hier zum Pluspol, anschließbar. Am Pin 17 des Steckers 16 ist beispielsweise eine bidirektionale Kommunikationsleitung zu anderen Elektronikgeräten im Kraftfahrzeug anschließbar. Alternativ kann die Kommunikationsleitung auch zwei Pins benötigen (z. B. bei Verwendung eines CAN-Buses). In einer dritten Alternative kann die Kommunikation jedoch auch per Funkübertragung vorgenommen werden. Anstelle einer Verbindung über einen Stecker 16 kann aus Platzspargründen auch eine direkte Verbindung der Anschlussleitungen mit der Platine vorgesehen werden (z. B. durch Löten, Bonden oder Schweißen). (Die Alternativen sind hier nicht dargestellt.)

Schließlich ist in Fig. 3 und in Fig. 4 ein erster Spannungsabgriff 15 zur Messung der Batteriespannung U_{Batt} gezeigt, der mit dem batteriepolseitigen (z. B. zum Minuspol) Widerstandsanschluß 10a leitend verbunden ist. Der zweite Spannungsabgriff zur Messung der Batteriespannung U_{Batt} wird durch den Pin 18 gebildet (z. B. zum Pluspol der Batterie).

In Fig. 4 sind weitere Details der Trägerplatine 12 bzw. der Elektronikeinheit 4 dargestellt. Die Trägerplatine 12 bzw. die Elektronikeinheit 4 weist eine Meß-, Auswerte- und Steuereinheit 20 auf. Die Einheit 20 erfaßt die Batteriespannung U_{Batt}, die Spannung U zwischen den beiden Lötstellen 14 und die Batterietemperatur. Aus der Spannung U kann der Batteriestrom (I) berechnet werden. Hierzu ist beispielsweise der Widerstandswert (R) des Widerstandselements 11 in der Einheit 20 abgespeichert. Die Einheit 20 weist vorzugsweise einen Mikroprozessor und einen Speicher auf. Auch kann die Einheit 20 übliche Verstärker und A/D-Wandler zur Meßaufbereitung enthalten. Die Einheit 20 kann beliebige weitere Batterie-Indikatorgrößen, wie z. B. den Ladezustand oder den Alterungszustand, ermittelt. Weiterhin kann die Einheit 20 ihrerseits über die Kommunikationsleitung nicht nur Informationen übertragen, sondern auch weitere Informationen von anderen Steuergeräten erhalten und diese mit den Batteriegrößen weiterverarbeiten. Die Kommunikationsleitung und die Versorgungsleitung zum Stecker 16 sind als Kabelbaum 21 zusammengefaßt dargestellt.

Abhängig von den der Einheit 20 vorliegenden Informationen kann diese einen Leistungsschalter 19 ansteuern, der eine im Widerstandsanschluß 10b vorliegende Unterbrechung schließen oder öffnen kann. Hierbei kann beispielsweise in Notfällen die Batterieversorgung des Kraftfahrzeuges abgeschaltet werden. Alternativ kann hierzu der Leistungsschalter 19 auch in einen der beiden Anschlusskabel zum Pluspol oder zum Minuspol der Batterie integriert und von der Einheit 20 angesteuert werden.

In Fig. 5a ist ergänzend lediglich schematisch eine zweite mögliche Konstruktion der integrierten Baueinheit bestehend aus Batteriesensor und Befestigungsvorrichtung dargestellt. Hierbei wird durch die strichpunktierte Linie die Bohrung für die Klemmschraube 2 angedeutet. Diese Konstruktion weicht nur darin von der ersten Konstruktion ab, daß der Batteriesensor 3, 4 örtlich stärker von der Klemmschraube 2 abgesetzt ist und damit von möglichen Verspannungen bei einer Befestigung des Klemmkörpers 1 entkoppelt ist.

Fig. 5b zeigt eine der Fig. 5a sehr ähnliche Konstruktion, bei der jedoch zwischen dem Klemmkörper 1 und dem Meßshunt 3 eine Verjüngung vorgesehen ist, um Materialspannungen im Klemmkörper 1 zu vermeiden.

In den Figuren 6a bis 7a sind weitere Ausgestaltungsmöglichkeiten des Meßshunts 3 gemäß der Erfindung bestehend aus dem Widerstandselement 11 und den beiden Widerstandsanschlüssen 10a und 10b sowie der Befestigung der Elektronikeinheit 4 bzw. deren Trägerplatine 12 dargestellt. Die Widerstandsanschlüsse 10a und 10b sind vorzugsweise (wie auch in Fig. 3) planar ausgebildete Kupferflächen. Das Material des Widerstandselements 1, vorzugsweise Manganin oder Zeranin, ist wie auch in Fig. 3 zwischen den Widerstandsanschlüße 10a und 10b angeordnet.

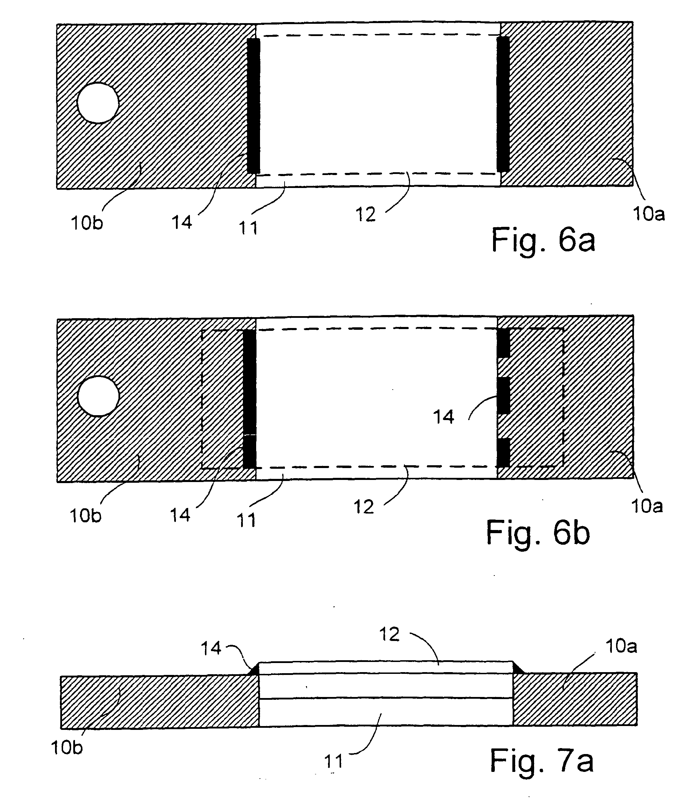

In den Figuren 6a bis 7a ist die Trägerplatine 12 der Elektronikeinheit 4 (auch ähnlich der SMD-Technik) über Lötstellen 14 an den Widerstandsanschlüssen 10a und 10b befestigt. Dabei bilden in Fig. 6a (und in Fig. 7a, Seitenansicht von Fig. 6a) die Lötstellen 14 eine langgezogene Linie entlang der Kante der Trägerplatine 12. Hierzu sind vorzugsweise an den Kanten der Trägerplatine zumindest zum Teil offene Leiterbahnen für die Lötstellen vorgesehen. Die Lötlinien 14 können auch unterbrochen sein bzw. sich auch aus beabstandeten Punkten zusammensetzen. Die Ausgestaltung nach Fig. 6a (bzw. Fig. 7a) setzt voraus, dass die Breite der Trägerplatine 12 nicht viel größer als die Breite des Widerstandelements 11 ist; denn die Verlötung muss möglichst nahe am Widerstandselement 11 vorgesehen werden. Gemäß der Erfindung ist die Konstruktion des Meßshunts dabei gemäß Fig. 7a derart, dass sich zwischen dem Widerstandselement 11 und der Trägerplatine 12 ein Hohlraum ergibt. Die Dicke des Widerstandselementes 11 ist also kleiner als die der Widerstandsanschlüsse 10a und 10b. Durch diesen Hohlraum ist es möglich, die Trägerplatine 12 bei Bedarf beidseitig zu bestücken.

Alternativ kann gemäß Fig. 6b die Trägerplatine 12 auch durch Lötstellen 14 an der Unterseite der Platine 12 mit den Widerstandsanschlüssen 10a und 10b möglichst nahe am Widerstandselement 11 verbunden sein (ähnlich Fig. 3). Im Unterschied zu Fig. 3 wird hierbei zur mechanischen Stabilisierung (wie in Fig. 6a) eine durchgezogen (Fig. 6b links) oder eine unterbrochene (Fig. 6b rechts) Lötlinie vorgesehen. Über die Lötstellen 14 wird das Widerstandselement 11 immer auch schaltungstechnisch in die Elektronikeinheit 4 integriert. Die Ausgestaltung nach Fig. 6b kann mit der Konstruktion des Meßshunts gemäß Fig. 7a kombiniert werden. Bei einer Ausgestaltung nach Fig. 6b kann die Breite der Trägerplatine 12 auch größer als die Breite des Widerstandelements 11 sein.

Bei jeder Ausgestaltung können anstelle von Lötstellen (14) auch Klebstellen (14), z.B. mittels eines elektrisch leitenden und wärmeleitenden Klebers, vorgesehen werden.

Grundsätzlich wird demnach die Elektronikeinheit 4 bzw. die Trägerplatine 12 der Elektronikeinheit 4 an den planaren Widerstandsanschlüssen 10a und 10b mittels eines elektrisch leitenden Materials 14 (z. B. Lot oder Kleber) befestigt. Die Löt- oder Klebestellen 14 dienen somit sowohl zur elektrischen bzw. schaltungstechnischen Integration des Meßshunts bzw. des Widerstandselements 11 in die Elektronikeinheit 4 als auch zur mechanischen Befestigung der Elektronikeinheit 4 bzw. deren Trägerplatine 12 am Meßshunt bzw. an dessen Widerstandsanschlüssen 10a und 10b.

## Patentansprüche

1. Batteriesensor (3, 4) umfassend einen Meßshunt (3) und eine Elektronikeinheit (4),
- wobei der Meßshunt (3) aus zwei planaren Widerstandsanschlüssen (10a, 1Ob) und einem zwischen den Widerstandsanschlüssen (10a, 10b) angeordneten planaren Widerstandselement (11) besteht und die Dicke des Widerstandselementes (11) kleiner als die Dicke der Widerstandstandsanschlüsse (10a, 10b) ist, und
- die Elektronikeinheit (4) bzw. deren Trägerplatine (12) an den Widerstandsanschlüssen (10a, 10b) mittels eines elektrisch leitenden Materials (14) befestigt ist derart, dass sich zwischen dem Widerstandselement (11) und der Trägerplatine (12) ein Hohlraum ergibt.

2. Batteriesensor nach Anspruch 1, **dadurch gekennzeichnet, dass** der Hohlraum derart ausgebildet ist, dass die Trägerplatine beidseitig bestückbar ist.

3. Batteriesensor nach einem der vorstehenden Ansprüche, **dadurch gekennzeichnet, dass** die Befestigung der Elektronikeinheit (4) bzw. der Trägerptatine (12) möglichst nahe am Widerstandselement (11) erfolgt.

4. Batteriesensor nach einem der vorstehenden Ansprüche, **dadurch gekennzeichnet, dass** die Befestigung der Elektronikeinheit (4) bzw. der Trägerplatine (12) an den Widerstandsanschlüssen (10a, 10b)- und insbesondere auch die schaltungstechnische Verbindung zwischen Widerstandselement (11) und Elektronikeinheit (4) - mittels einer durchgezogenen oder unterbrochenen Lötlinie erfolgt.

## Claims

1. A battery sensor (3, 4) comprising a measuring shunt (3) and an electronic unit (4),
- wherein the measuring shunt (3) comprises two planar resistance connections (10a, 10b) and a planar resistance element (11) arranged between the resistance connections (10a, 10b), and the thickness of the resistance element (11) is smaller than the thickness of the resistance connections (10a, 10b), and
- the electronic unit (4) or its carrier circuit board (12) is fastened to the resistance connections (10a, 10b) by means of an electrically conductive material (14) such that a cavity is produced between the resistance element (11) and the carrier circuit board (12).

2. A battery sensor according to claim 1, **characterised in that** the cavity is configured in such a way that the carrier circuit board can be equipped on both sides.

3. A battery sensor according to any one of the preceding claims, **characterised in that** the electronic unit (4) or the carrier circuit board (12) is fastened as close as possible to the resistance element (11).

4. A battery sensor according to any one of the preceding claims, **characterised in that** the fastening of the electronic unit (4) or the carrier circuit board (12) to the resistance connections (10a, 10b) - and especially also the connection in terms of circuitry between the resistance element (11) and the electronic unit (4) - takes place by means of a continuous or interrupted soldering line.

## Revendications

1. Capteur de batterie (3, 4) comprenant un shunt de mesure (3) et une unité électronique (4), dans lequel
- le shunt de mesure (3) est constitué de deux branchements de résistance (10a, 10b) planaires et d'une grille de résistance (11) planaire disposé entre les branchements de résistance (10a, 10b) et l'épaisseur de la grille de résistance (11) est inférieure à l'épaisseur des branchements de résistance (10a, 10b), et
- l'unité électronique (4), ou sa platine porteuse (12) est fixée sur les branchements de résistance (10a, 10b) au moyen d'un matériau (14) conducteur d'électricité de façon qu'il se forme un espace creux entre la grille de résistance (11) et la platine porteuse (12).

2. Capteur de batterie selon la revendication 1,
**caractérisé en ce que**
l'espace creux est réalisé de façon que la platine porteuse peut être équipée des deux côtés.

3. Capteur de batterie selon l'une des revendications précédentes,
**caractérisé en ce que**
la fixation de l'unité électronique (4) et de la platine porteuse (12) est réalisée le plus près possible de la grille de résistance (11).

4. Capteur de batterie selon l'une des revendications précédentes,
**caractérisé en ce que**
la fixation de l'unité électronique (4) et de la platine porteuse (12) est réalisée sur les branchements de résistance (10a, 10b) - et en particulier également la liaison technique du circuit entre la grille de résistance (11) et l'unité électronique (4)- au moyen d'une ligne de brasage continue ou discontinue.
